# FASCICULE DE BREVET EUROPEEN

(11) **EP 2 192 612 B1**
(45) Date de publication et mention de la délivrance du brevet: **14.01.2015**
(21) Numéro de dépôt: 09014049.2
(22) Date de dépôt: 10.11.2009
(51) Int. Cl.: H01L 21/768, H01L 23/48, H01L 25/065, H01L 21/98

(54) **Procédé pour empiler et interconnecter des circuits intégrés**
Verfahren zum Stapeln und Vernetzen von integrierten Schaltkreisen
Method for stacking and interconnecting integrated circuits

(30) Priorité: 26.11.2008 FR 0806644
(43) Date de publication de la demande: 02.06.2010
(73) Titulaire: STMicroelectronics Rousset SAS, 13790 Rousset (FR)
(72) Inventeur: Dunne, Brendan, 13120 Gardanne (FR)
(74) Mandataire: Marchand, André

(56) Documents cités:
- WO-A-99/56508
- WO-A1-2007/024022
- JP-A- 2002 050 736
- US-A1- 2002 135 062
- US-A1- 2003 060 034
- US-A1- 2005 101 054

## Description

La présente invention concerne la fabrication de circuits intégrés et plus particulièrement la fabrication d'un empilement de puces à circuits intégrés comme indiqué dans la revendication 1.

L'interconnexion des circuits intégrés est devenue un problème de plus en plus complexe avec l'accroissement de leur complexité. Pour réduire le plus possible la surface nécessaire à l'interconnexion de circuits intégrés, il est généralement prévu des moyens d'interconnexion tels que des supports de puces ("chip carrier") ou des cartes de circuit imprimé haute densité.

Depuis des années, les techniques de réalisation de "circuits intégrés tridimensionnels" apparaissent comme la solution idéale pour réduire la surface occupée par un ensemble de circuits intégrés interconnectés. Cependant, diverses contraintes technologiques ont empêché la mise en oeuvre rapide d'une telle solution.

Classiquement, un circuit intégré tridimensionnel est un empilement de deux ou plusieurs puces de semi-conducteur dans lesquelles des circuits intégrés sont intégrés. Des circuits intégrés identiques ou hétérogènes peuvent être empilés pour obtenir une circuiterie haute densité 3D, par exemple un empilement de N puces mémoire permettant de réaliser une matrice mémoire dans un volume réduit.

Les circuits intégrés empilés sont souvent réalisés au "niveau du wafer" ("wafer level"), c'est-à-dire lorsque les puces n'ont pas encore été séparées du "wafer" au sein duquel elles ont été fabriquées (un wafer étant généralement une plaque de semi-conducteur). Les procédés d'empilement dits "wafer sur wafer" comprennent une étape d'empilement de deux ou plusieurs wafers qui sont alignés, interconnectés et assemblés, puis découpés pour obtenir des circuits intégrés empilés discrets.

A cet effet, des vias traversant les wafers sont conventionnellement créés avant que les différents wafers soient assemblés. Les wafers peuvent être assemblés avant ou après une étape d'amincissement et peuvent être assemblés face avant contre face avant ou face avant contre face arrière. Les techniques classiques d'assemblage de wafers comprennent ainsi l'interconnexion électrique simultanée (i.e. au moment de l'assemblage) de plages de contact réalisées sur une face avant ou arrière des wafers ou réalisées sur les deux faces. Ces procédés sont peu pratiques à mettre en oeuvre lorsque plusieurs wafers sont empilés. Après une étape d'alignement des différents wafers, l'étape d'assemblage et d'interconnexion des wafers est une opération délicate en raison de la grande taille de ces derniers. De plus, le matériau d'interconnexion, par exemple une soudure, n'offre pas la flexibilité et la ductilité que l'on peut souhaiter pour assembler de grands wafers. Enfin, la fabrication des vias traversants dans chaque wafer nécessite diverses étapes et est souvent complexe et coûteuse à mettre en oeuvre. Ainsi, il est prévisible que la maîtrise des techniques d'interconnexion et d'alignement tridimensionnel sera un défi majeur dans un proche avenir.

De nombreux procédés différents ont été proposés afin de fabriquer des vias traversant ("through vias"), par exemple le procédé décrit dans la demande de brevet américaine N° 2005/0101054. Ce procédé comprend une étape de formation d'une tranchée sur le dessus d'un wafer de semi-conducteur. La tranchée est ensuite remplie d'un matériau diélectrique. Le wafer est ensuite aminci jusqu'à ce que le fond de la tranchée soit atteint, formant ainsi une région isolée électriquement du reste du wafer, délimitée par la tranchée isolante. Le matériau remplissant la région électriquement isolée est ensuite retiré et la région isolée est remplie d'un matériau électriquement conducteur, qui permet d'interconnecter des contacts sur les faces avant et arrière du wafer.

Un autre procédé, décrit dans la demande de brevet américaine 2008/0203556, propose une approche opposée. On utilise ici un wafer en un matériau conducteur. Des tranchées sont formées et sont comme précédemment remplies d'un matériau diélectrique. Elles isolent ainsi le matériau conducteur qu'elles entourent du reste du wafer conducteur, ce matériau formant ainsi une interconnexion entre des contacts en face avant et des contacts en face arrière.

Dans le brevet américain N° 6,642,081, un circuit intégré empilé est obtenu en assemblant la face avant d'un premier wafer sur une face d'un second wafer, puis en amincissant la face arrière du premier wafer jusqu'à atteindre une épaisseur qui est telle que des portions de plots conducteurs dépassent de la face arrière du wafer aminci. Les extrémités de ces plots sont ensuite assemblées sur des plages de contact situées sur la face avant d'un troisième wafer.

Le document JP 2002 050 736 A décrit en relation avec ses figures 4A à 4D un procédé d'empilement d'au moins deux substrats dans lequel on réalise un trou qui pénètre dans les deux substrats et dans des électrodes de chaque substrat. Le trou est isolé électriquement au moyen d'un film d'oxyde sélectif qui ne se dépose pas sur le matériau des électrodes. Un matériau conducteur, tel de la soudure, est ensuite injecté dans le trou pour former une électrode de liaison qui est en contact électrique latéral avec des électrodes de chaque substrat.

Il peut être souhaité de prévoir une technique alternative à celle décrite par JP 2002 050 736 pour empiler et interconnecter des circuits intégrés d'une manière simple et fiable sans nécessiter un oxyde sélectif.

Le document US 2005/0101054 décrit un procédé de formation d'un via comprenant des étapes de formation d'une tranchée dans un substrat, de remplissage de la tranchée avec un matériau diélectrique, de formation d'une plage de contact (8, 12) au-dessus de la tranchée, d'amincissement du substrat par sa face arrière, jusqu'à atteindre le fond de la tranchée, de retrait du semi-conducteur s'étendant à l'intérieur de la tranchée, de manière à faire apparaître une cavité, puis de métallisation de la cavité pour réaliser un via conducteur qui est en contact électrique frontal avec la face inférieure de la plage de contact.

Des modes de réalisation de l'invention concernent un procédé pour empiler et interconnecter des circuits intégrés, comprenant des étapes consistant à fournir au moins deux substrats, former dans chaque substrat au moins une tranchée ou un puits délimitant un périmètre fermé dans chaque substrat, remplir la tranchée ou le puits de chaque substrat avec un matériau isolant, former, sur chaque substrat, au moins un circuit intégré et au moins une zone conductrice connectée au circuit intégré, amincir chaque substrat jusqu'à atteindre au moins le fond de la tranchée ou du puits, pour obtenir dans chaque substrat au moins une région isolée électriquement délimitée par la tranchée ou le puits, assembler les substrats ensemble afin de former un empilement de substrats, pratiquer au moins un trou à travers les substrats assemblés de telle sorte que le trou passe au moins partiellement à travers les zones conductrices et qu'il passe par la région isolée de chaque substrat, et remplir le trou d'un matériau électriquement conducteur afin d'obtenir une colonne conductrice qui traverse la région isolée de chaque substrat et est en contact électrique latéral avec les zones conductrices.

Selon un mode de réalisation, le procédé comprend une étape consistant à découper l'empilement de substrats en au moins un empilement individuel de puces.

Selon un mode de réalisation, l'étape de découpe est effectuée avant les étapes de création d'au moins un trou dans les substrats assemblés.

Selon un mode de réalisation, le procédé comprend une étape d'amincissement d'au moins un substrat, effectuée après l'étape d'assemblage des substrats.

Selon un mode de réalisation, le procédé comprend une étape de retrait partiel du matériau conducteur d'au moins une colonne conductrice et une étape de remplacement du matériau conducteur retiré par un matériau non conducteur.

Selon un mode de réalisation, le procédé comprend une étape consistant à réaliser dans au moins un des substrats, avant assemblage des substrats, des vias conducteurs qui interconnectent au moins deux zones conductrices du substrat destinées à être également interconnectées par une colonne conductrice.

Selon un mode de réalisation, le procédé comprend des étapes consistant à assembler au moins un premier, un second et un troisième substrat, et interconnecter au moins une zone conductrice du premier substrat avec au moins une zone conductrice du second substrat au moyen d'une première colonne conductrice en ne connectant aucune zone conductrice du troisième substrat à la colonne conductrice.

Selon un mode de réalisation, le procédé comprend des étapes consistant à assembler au moins un premier et un second substrat pour obtenir un empilement intermédiaire de substrats, interconnecter au moins une zone conductrice du premier substrat avec au moins une zone conductrice du second substrat au moyen d'une première colonne conductrice, assembler au moins un troisième substrat à l'empilement intermédiaire pour obtenir un empilement de substrats final, et interconnecter au moins une zone conductrice du premier et/ou du second substrat avec au moins une zone conductrice du troisième substrat, au moyen d'une seconde colonne conductrice.

Ces caractéristiques seront mieux comprises à la lumière de la description suivante de modes de réalisation d'un procédé pour empiler et interconnecter des circuits intégrés selon l'invention, faite à titre non limitatif en relation avec les figures jointes parmi lesquelles :
- Les figures 1A à 1H sont des vues en coupe de différentes étapes d'un premier mode de réalisation du procédé selon l'invention,
- La figure 1I illustre un empilement de puces obtenu à partir d'un empilement de wafers illustré sur la figure 1H,
- La figure 2 est une vue en perspective d'un exemple d'une région isolée réalisée lors d'étapes illustrées sur les figures 1A à 1D,
- Les figures 3A et 3B sont des vues en coupe de deux étapes d'un second mode de réalisation du procédé selon l'invention,
- La figure 4 est une vue en coupe partielle d'un empilement de wafers réalisé selon un troisième mode de réalisation du procédé selon l'invention,
- La figure 5 est une vue en coupe partielle d'un empilement de wafers réalisé selon un quatrième mode de réalisation du procédé selon l'invention,
- La figure 6 est une vue en coupe partielle d'un empilement de wafers réalisé selon un cinquième mode de réalisation du procédé selon l'invention, et
- Les figures 7A à 7C représentent schématiquement une variante de réalisation d'étapes illustrées sur les figures 1A à 1D.

Des modes de réalisation de la présente invention comprennent une étape consistant à assembler au moins deux wafers avant formation de colonnes électriquement conductrices dans les wafers assemblés. On réalise ainsi dans un premier temps un empilement de wafers qui ne sont pas encore interconnectés et ne comprennent pas de moyens d'interconnexion. Ensuite, des trous collectifs sont formés à travers l'empilement de wafers (on entend par "trou collectif" un trou qui traverse plusieurs wafers). Un matériau conducteur est ensuite introduit dans les trous afin d'obtenir des colonnes conductrices que l'on peut assimiler à des "vias traversants collectifs", soit des vias traversants qui traversent plusieurs wafers et interconnectent électriquement au moins certaines zones conductrices des wafers. Lorsque le wafer comprend un matériau conducteur ou semi-conducteur, des modes de réalisation de l'invention peuvent comprendre des étapes préliminaires de formation de régions isolées là où les trous doivent être pratiqués, afin d'isoler le matériau conducteur qui sera introduit dans ces trous pour former les colonnes conductrices.

Des modes de réalisation de la présente invention vont maintenant être décrits plus en détail. Ces modes de réalisation sont exposés à titre non limitatif et sont susceptibles de diverses mises en oeuvre et variantes à la portée de l'homme de l'art. Dans les modes de réalisation décrits ci-dessous, le matériau du wafer est un matériau semi-conducteur et des étapes sont prévues pour empêcher des courts-circuits entre les colonnes conductrices et le matériau semi-conducteur. Cependant, des modes de réalisation de la présente invention pourraient également être mis en oeuvre avec d'autres types de substrats. Par conséquent, le terme "wafer" ne se limite pas aux wafers semi-conducteurs et peut faire référence à tout autre type de substrat sur lequel des circuits électroniques pourraient être intégrés ou enchâssés.

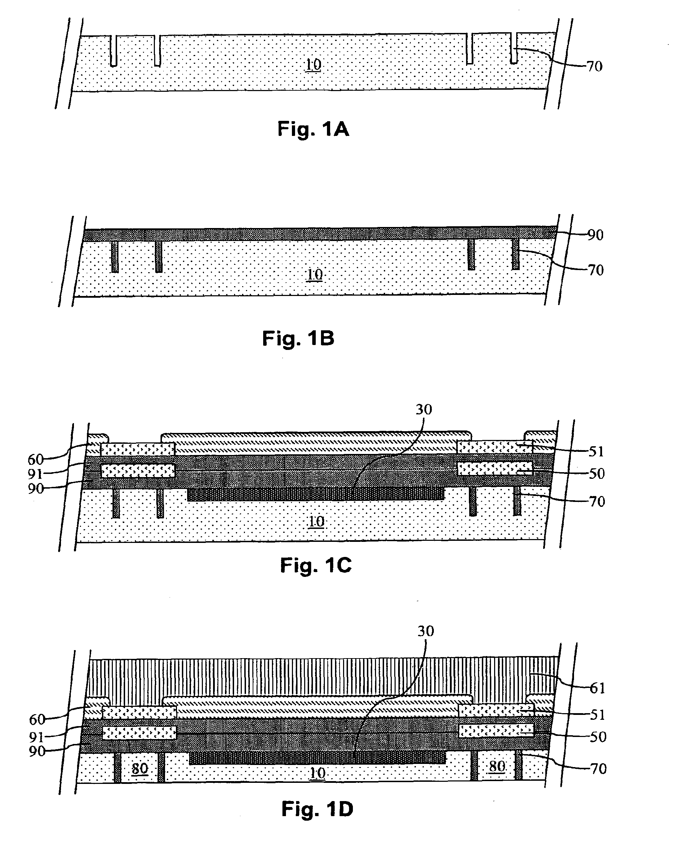

Les figures 1A à 1H représentent différentes étapes d'un premier mode de réalisation d'un procédé pour empiler et interconnecter des circuits intégrés selon l'invention. Ce procédé est mis en oeuvre au moyen de wafers dans lesquels plusieurs circuits intégrés sont réalisés. Par souci de simplification des figures, seules des zones partielles des wafers sont représentées. Ces zones correspondent à une région des wafer comprenant un circuit intégré. Pour des raisons de clarté, les figures ne sont pas à l'échelle et sont étirées selon un axe vertical correspondant à l'épaisseur des wafers.

Le procédé comprend des étapes préliminaires de formation de tranchées 70 sur la face avant d'un wafer 10, tel qu'illustré sur la figure 1A. Ces étapes peuvent comprendre des étapes de dépôt d'une couche de résine photosensible, d'exposition de la résine avec un masque de photolithographie, de gravure de la résine exposée, de gravure du wafer puis de retrait de la résine photosensible, etc. L'étape de gravure du wafer peut être effectuée par gravure ionique réactive profonde (DRIE). Chaque tranchée délimite un périmètre fermé dans le wafer et présente par exemple une forme annulaire. Bien qu'une telle forme annulaire soit facilement et communément utilisée en microélectronique, les tranchées peuvent être d'une forme différente, comme par exemple rectangulaire ou polygonales, selon les techniques de traitement utilisées et l'application visée. En outre, les parois de la tranchée peuvent être verticales, en biais ou de toute autre forme souhaitée ou imposée par le procédé utilisé.

Lors d'une étape illustrée sur la figure 1B, les tranchées sont remplies d'un matériau électriquement isolant, par exemple un matériau diélectrique 90. Au cours de cette étape, le wafer 10 peut est simultanément recouvert d'une couche du matériau 90 formant une couche diélectrique sur la face avant du wafer. Le matériau diélectrique 90 peut par exemple être un oxyde TEOS (TétraEthOxySilane) déposé en utilisant des procédés connus tels que le dépôt chimique en phase vapeur. Selon les conditions de traitement, comme par exemple la température, l'étape de remplissage des tranchées peut optionnellement être effectuée après formation de circuits intégrés sur la face avant du wafer.

L'étape de remplissage des tranchées 70 peut être effectuée en prétraitement ("preprocessing") ou en milieu de traitement ("mid processing") afin de déposer le matériau diélectrique 90 sans contraintes de température. Habituellement, la température de dépôt d'un oxyde TEOS est typiquement d'environ 460 à 480°C. Le matériau diélectrique ainsi fait présente une constante diélectrique et une épaisseur satisfaisantes, et il est aisé de remplir les tranchées.

Si la couche de matériau diélectrique 90 est déposée pendant la phase de prétraitement, elle est ensuite retirée par exemple au moyen du traitement CMP ("Chemical Mechanical Polishing" ou polissage chimio-mécanique, combinant l'abrasion mécanique et la gravure chimique).

Si le matériau diélectrique 90 est déposé sur la face avant du wafer en milieu de traitement, la couche diélectrique peut intervenir dans la fabrication des circuits intégrés, par exemple en tant que couche IMD ("Inter Metal Dielectric" ou diélectrique intermétallique). Dans ce cas, il n'est pas nécessaire de la retirer. On suppose dans ce qui suit que c'est cette solution qui a été retenue, de telle sorte que la couche de matériau diélectrique 90 apparaît dans les figures suivantes.

Après la formation des tranchées 70 et le dépôt du matériau diélectrique 90, le processus habituel de fabrication des zones de circuits intégrés peut être effectué ou poursuivi (formation des transistors, formation et gravure des couches métalliques sur la face avant du wafer, etc.).

On atteint ainsi une étape illustrée sur la figure 1C, au cours de laquelle le wafer 10 comprend des circuits intégrés 30 (seul un circuit intégré 30 est représenté schématiquement sous forme de bloc sur la vue partielle de la figure 1C et dans ce qui suit). Lors de la fabrication des circuits intégrés 30, une ou plusieurs zones conductrices telles que des plages de contact 50 ont également été formées sur le matériau diélectrique 90 sur la face avant du wafer 10. Les zones conductrices 50 sont connectées à des circuits intégrés 30, sont situées au-dessus des tranchées 70 et sont électriquement isolées du wafer par la couche diélectrique 90. Ces zones conductrices peuvent comprendre n'importe quel matériau conducteur connu, par exemple de l'aluminium, du cuivre, du silicium polycristallin, du tungstène, un alliage, etc., selon le processus de fabrication mis en oeuvre.

D'autres couches diélectriques et d'autres zones conductrices peuvent également avoir été formées. Dans l'exemple illustré sur la figure 1C, le wafer comprend également une couche diélectrique 91 et des zones conductrices telles que des plages de contact 51. Une couche de passivation 60 a également été déposée sur le dessus du wafer 10.

Lors d'une étape illustrée sur la figure 1D, la face avant du wafer 10 est placée sur un support de wafer temporaire 61. Le wafer est ensuite soumis à une étape d'amincissement par abrasion et/ou gravure de sa face arrière jusqu'à ce qu'au moins les fonds des tranchées 70 soient atteints. L'étape d'amincissement, généralement appelée "backlap" ou "backgrinding", est effectuée par abrasion mécanique ou gravure chimique de la face arrière du wafer, ou par abrasion mécanique suivie de gravure chimique. Des techniques connues sont par exemple le polissage chimio-mécanique, la gravure humide, la gravure sèche ADP (Atmospheric Downstream Plasma), etc.. L'étape d'amincissement peut continuer au-delà du point où les fonds des tranchées 70 sont atteints.

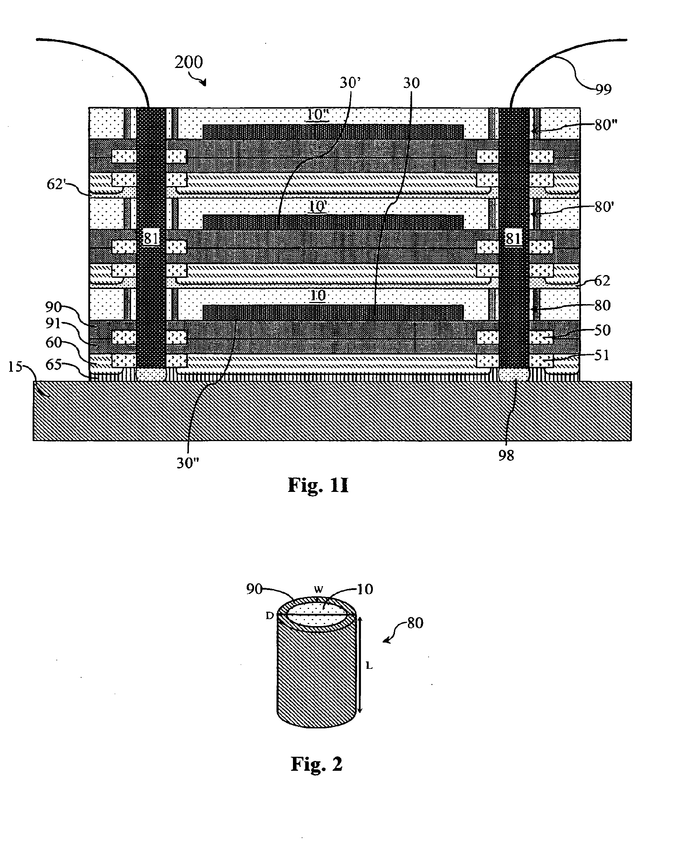

On obtient ainsi des régions isolées 80. Les régions 80 sont en effet électriquement isolées relativement au reste du wafer puisqu'elles sont entourées par les tranchées isolantes 70 (qui peuvent être considérées comme des parties des régions isolées 80). Par exemple, et tel qu'illustré sur la figure 2, une région isolée 80 présente un diamètre D d'environ 50 microns en incluant la largeur de la tranchée 70, une largeur de tranchée W d'environ 5 microns et une profondeur L d'environ 100 microns.

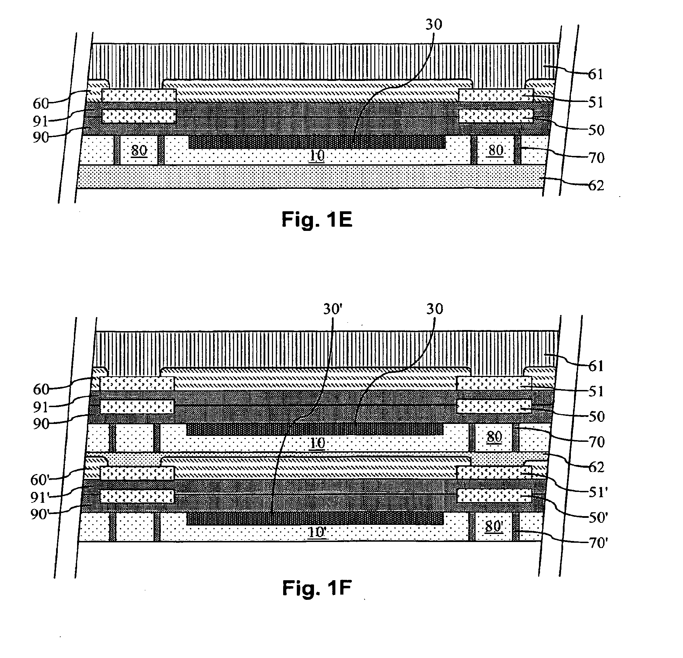

Une couche de matériau adhésif 62 est ensuite appliquée sur l'arrière du wafer 10, tel qu'illustré sur la figure 1E.

On suppose maintenant qu'un second wafer 10', représenté sur la figure 1F, est ensuite réalisé ou a été réalisé avant ou en même temps que le wafer 10. Comme le wafer 10, le wafer 10' présente des circuits intégrés 30' (un seul étant représenté), des régions isolées 80' délimitées par des tranchées isolantes 70', des plages de contact 50', 51' agencées respectivement au-dessus de chaque région isolée, des couches diélectriques 90', 91' sur lesquelles les plages de contact reposent respectivement et une couche de passivation 60'. Alternativement, la couche adhésive 62 peut être appliquée sur la face avant du wafer 10' au lieu de la face arrière du wafer 10.

Les circuits intégrés 30' peuvent être les mêmes que les circuits intégrés 30 du wafer 10 ou d'un autre type. Le second wafer 10' peut être aminci avant ou après l'assemblage avec le wafer 10 (selon la face du wafer 10' qui est assemblée avec le wafer 10).

Ensuite, tel qu'illustré sur la figure 1F, le second wafer 10' est aligné et assemblé au wafer 10, ici dans une configuration face avant contre face arrière. La face avant du wafer 10' et la face arrière du wafer 10 sont ainsi liées par la couche adhésive 62. Dans d'autres modes de réalisation, peut également être prévu un assemblage face avant contre face avant.

La couche adhésive 62 assure un assemblage adapté des premier et second wafers 10, 10' présentant la souplesse nécessaire. Le matériau de la couche adhésive 62 peut également posséder d'autres propriétés telles que des propriétés de dissipation thermique, de protection physique, etc. Cependant, d'autres procédés d'assemblage de wafers connus de l'homme de l'art peuvent être utilisés, comme par exemple l'enduction centrifuge d'une couche de polymère adhésive, etc.

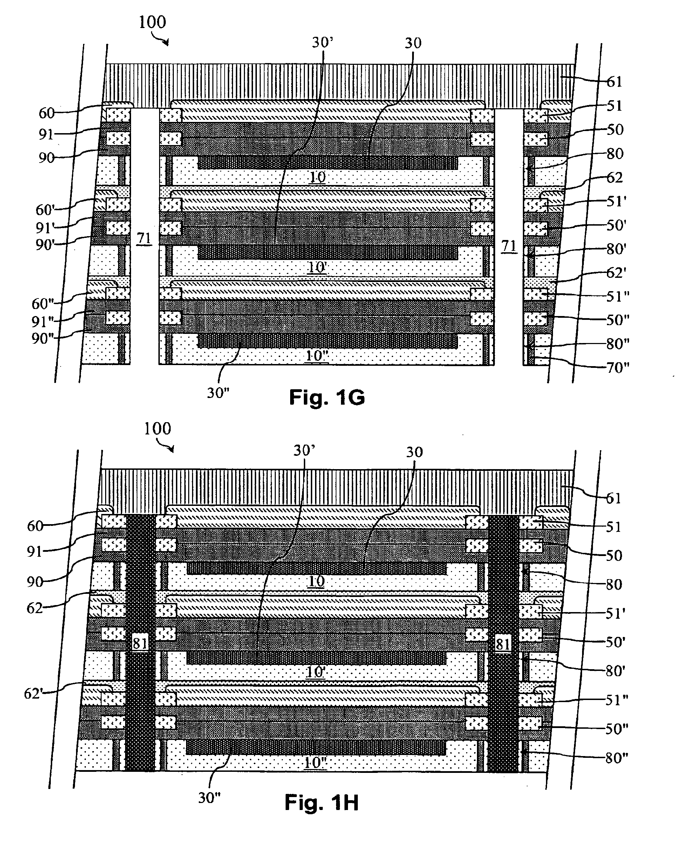

D'autres étapes du procédé de l'invention peuvent être prévues pour ajouter d'autres wafers à l'assemblage initial de deux wafers. Les autres wafers sont empilés d'une manière similaire avec leurs régions isolées alignées verticalement. Par exemple, tel qu'illustré sur la figure 1G, un troisième wafer 10" est empilé avec les wafers 10, 10'. Comme les wafers 10, 10', le wafer 10" comprend des circuits intégrés 30", des régions isolées 80" délimitées par des tranchées isolantes 70", des plages de contact 50", 51" agencées au-dessus des régions isolées, des couches diélectriques 90", 91" et une couche de passivation 60". Une seconde couche adhésive 62' est prévue pour assembler le wafer 10" à l'empilement des wafers 10, 10'.

Un empilement final 100 de wafers est ainsi obtenu. Des trous 71 sont ensuite pratiqués à travers les différents wafers, par exemple au moyen d'un laser. Les trous 71 passent à travers le wafer 10", les couches diélectriques 90", 91", les plages de contact 50", 51", la couche adhésive 62', le wafer 10', les couches diélectriques 90', 91', les plages de contact 50', 51', la couche adhésive 62, le wafer 10, les couches diélectriques 90, 91 et les plages de contact 50, 51. Les trous 71 sont pratiqués de telle sorte qu'ils passent à travers les régions isolées 80, 80', 80" qui sont alignées verticalement dans l'empilement de wafers.

Lors d'une étape illustrée sur la figure 1H, un matériau conducteur est ensuite déposé dans les trous 71. Des techniques telles que l'électrolyse ou l'application de pâte conductrice peuvent être utilisées pour remplir les trous 71 avec le matériau conducteur souhaité. Des colonnes 81 de matériau conducteur sont ainsi réalisées dans les trous 71. Les colonnes conductrices sont isolées du matériau des wafers 10, 10', 10" grâce aux tranchées remplies du matériau diélectrique. En outre, puisque les colonnes conductrices 81 traversent les différentes plages de contact 50, 51, 50', 51', 50", 51" de l'empilement, un contact électrique latéral est obtenu entre les bords des plages de contact dans les zones percées de celles-ci et les bords des colonnes conductrices passant à travers les zones percées des plages de contact. On obtient par conséquent des interconnexions de wafers.

Enfin, tel qu'illustré sur la figure 1I, l'empilement de wafers est retiré du support temporaire 61 et est découpé pour obtenir des empilements de puces 200 individuels de type "puce sur puce" ("die on die"). Pour l'utilisation des empilements de puces, des connexions avec des éléments extérieurs peuvent être réalisées grâce aux extrémités des colonnes conductrices. Par exemple, des liaisons par fils 99 peuvent être prévues en connectant ultrasoniquement des fils sur l'extrémité supérieure des colonnes conductrices. Des bourrelets de soudure 98 peuvent également être prévus sous les extrémités inférieures des colonnes conductrices, pour connecter l'empilement de puces à un support d'interconnexion 15. Une couche de matériau 65, ayant par exemple des propriétés de dissipation thermique ou améliorant l'adhésion de l'empilement de puces 200 sur le support 15, peut également être agencée entre l'empilement et le support.

Dans d'autres modes de réalisation, des plages de contact spécifiques peuvent être prévues au moment de la fabrication des wafers de manière que ces plages spécifiques s'étendent sur la face accessible des puces supérieures ou sur la face accessible des puces inférieures des empilements de puces. Ces plages de contact spécifiques peuvent être connectées aux autres plages de contact via des pistes conductrices selon des techniques conventionnelles de re-routage.

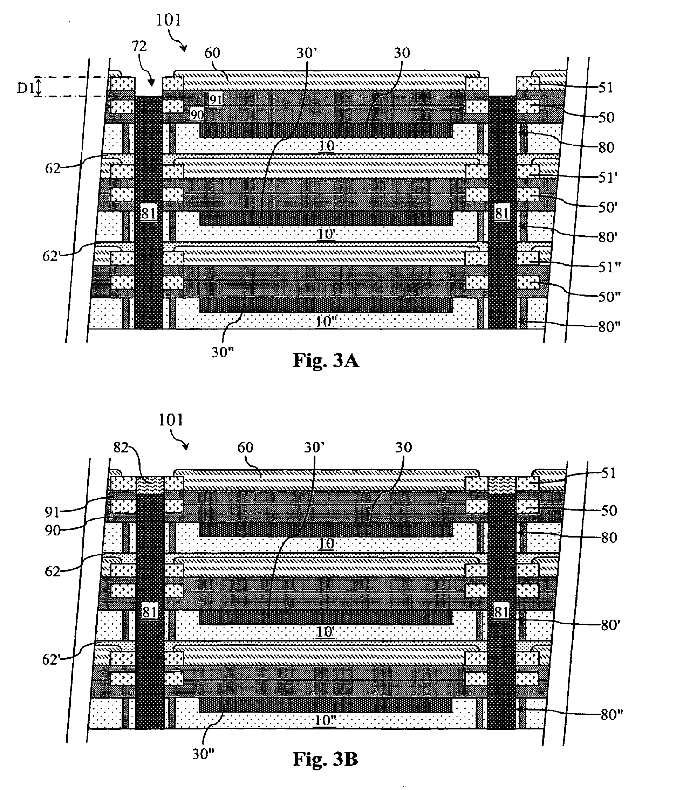

Les figures 3A et 3B illustrent un empilement de wafers 101 effectué selon un second mode de réalisation du procédé de l'invention. Tel que précédemment indiqué, seule une zone de chaque wafer comprenant un seul circuit intégré est représentée.

Dans ce mode de réalisation, trois wafers 10, 10', 10" ont été fabriqués, assemblés et interconnectés par des colonnes conductrices 81 de la manière décrite ci-dessus. Ensuite, comme illustré sur la figure 3A, le matériau conducteur est retiré dans les parties supérieures des colonnes conductrices 81, par exemple par gravure, jusqu'à une profondeur D1. Un trou 72 est ainsi obtenu. La profondeur D1 du trou est choisie de telle sorte que les plages de contact 51 sur la face avant du wafer supérieur 10 ne sont plus connectées aux autres plages de contact qui sont en contact avec les colonnes conductrices. Le trou 72 est ensuite rempli d'un matériau 82, comme par exemple un matériau isolant, tel qu'illustré sur la figure 3B.

Ce mode de réalisation peut être mis en oeuvre pour diverses raisons, par exemple pour couper les connexions électriques entre d'une part les plages de contact sur la face avant du wafer supérieur et d'autres part les plages de contact enfouies du wafer supérieur 10 et les plages de contact des wafers inférieurs 10', 10". Ce mode de réalisation peut également être mis en oeuvre lorsque la face avant du wafer supérieur ne comprend aucune plage de contact verticalement alignée avec les colonnes conductrices. Dans ce cas, les colonnes conductrices débouchent sur la face avant du wafer supérieur et il peut être souhaité, pour la sécurité du circuit, de cacher les colonnes conductrices afin d'empêcher des tierces personnes de capter les signaux électriques présents dans les colonnes conductrices.

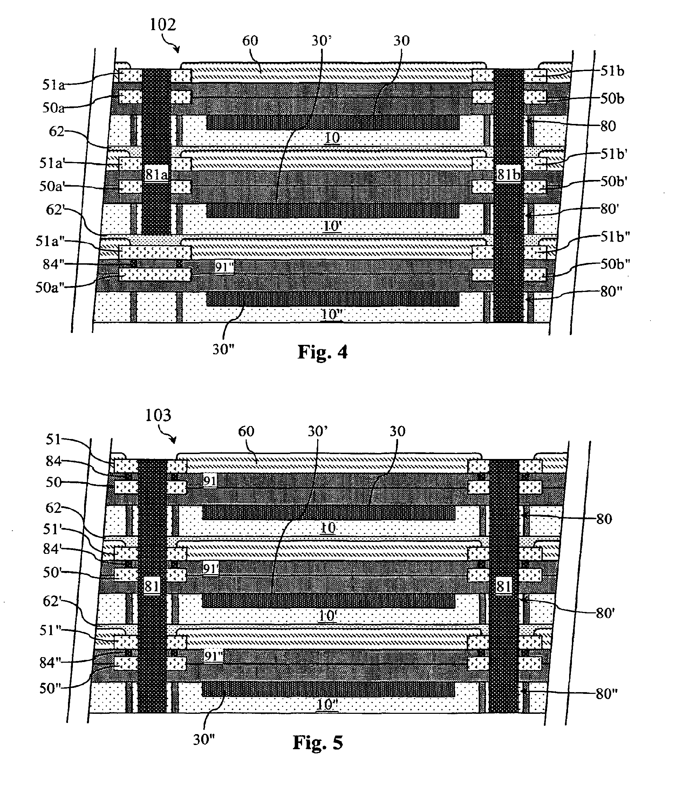

La figure 4 illustre un empilement de wafers 102 selon un troisième mode de réalisation du procédé de l'invention.

Dans ce mode de réalisation, deux wafers 10, 10', ont été fabriqués et assemblés tel que décrit ci-dessus. Un premier trou a été formé, traversant complètement les wafers 10, 10' et rempli avec un matériau conducteur, afin de créer une première colonne conductrice 81a qui interconnecte des plages de contact verticalement alignées 50a, 51a du wafer 10 et 50a', 51a' du wafer 10'. Un troisième wafer 10" a ensuite été assemblé aux wafers 10, 10' pour obtenir un empilement de wafers 10, 10', 10". Un second trou a ensuite été formé, traversant complètement l'empilement de wafers et rempli avec un matériau conducteur afin de créer une seconde colonne conductrice 81b qui interconnecte des plages de contact verticalement alignées 50b, 51b du wafer 10, 50b', 51b' du wafer 10' et 50b", 51b" du wafer 10".

De plus, lorsque le wafer 10" a été traité pour créer les plages de contact 50a", 51a", des vias conducteurs 84" de type conventionnel ont été fabriqués pour interconnecter les plages de contact 50a", 51a", par exemple en formant des ouvertures dans une couche diélectrique 91", puis en remplissant les ouvertures avec un matériau conducteur.

La figure 5 illustre un empilement de wafers 103 selon un quatrième mode de réalisation du procédé de l'invention.

Dans ce mode de réalisation, un empilement de wafers 10, 10', 10" a été réalisé. Le wafer 10 comprend des plages de contact 50, 51, le wafer 10' comprend des plages de contact 50', 51' et le wafer 10" comprend des plages de contact 50", 51". Des vias conducteurs 84 passent à travers une couche diélectrique 91 et interconnectent les plages de contact 50, 51 du wafer 10. De la même façon, des vias conducteurs 84' passent à travers une couche diélectrique 91' et interconnectent les plages de contact 50', 51' du wafer 10'. Des vias conducteurs 84" passent à travers une couche diélectrique 91" et interconnectent les plages de contact 50", 51" du wafer 10".

Les wafers 10, 10', 10" ont été assemblés et connectés tel que décrit ci-dessus en relation avec les figures 1E à 1H, en formant des colonnes conductrices 81. Les colonnes conductrices 81 interconnectent les plages de contact 50, 51 du wafer 10 avec les plages de contact 50', 51' du wafer 10' et les plages de contact 50", 51" du wafer 10". Des vias 84, 84', 84" ont été également formés dans chaque wafer et permettent d'obtenir une meilleure interconnexion (résistance série plus faible) entre des plages de contact appartenant au même wafer, ici entre les plages de contact 50 et 51, 50' et 51', et 50" et 51".

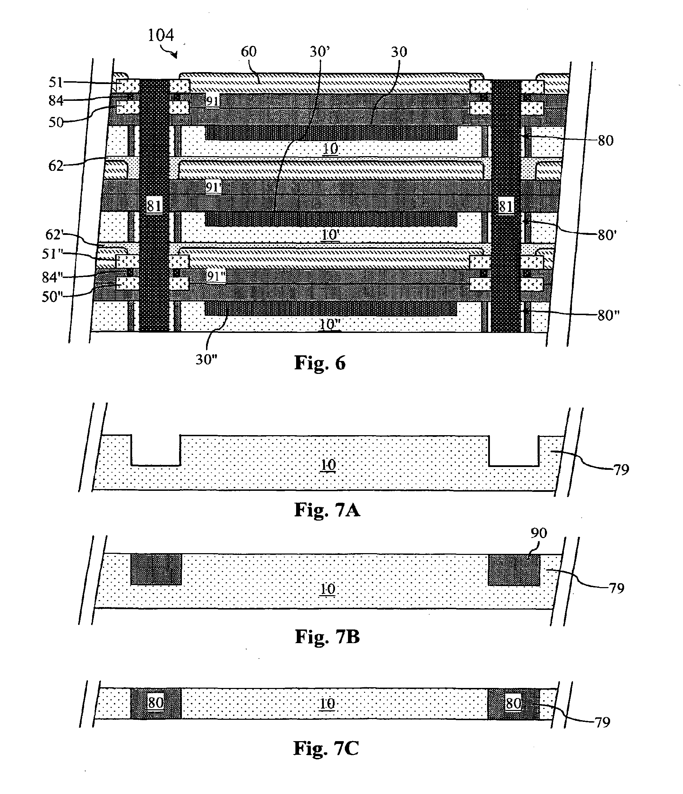

La figure 6 illustre une vue d'un empilement 104 de wafers selon un cinquième mode de réalisation du procédé de l'invention. L'empilement de wafers 104 diffère de l'empilement 103 en ce qu'au moins une colonne conductrice 81 ne passe pas à travers des plages de contact du wafer 10', de telle sorte que la colonne conductrice 81 n'interconnecte que des plages de contact 50, 51 du wafer 10 et des plages de contact 50", 51" du wafer 10". Bien entendu, certaines autres plages de contact du wafer 10' peuvent être connectées à des plages de contact du wafer 10, 10" par une colonne conductrice située dans une autre région des wafers, qui n'apparaissant pas sur la figure.

En règle générale, l'homme de l'art notera que les différents types d'interconnexions décrits ci-dessus, au moyen de colonnes conductrices, peuvent être combinés au sein du même empilement de wafers pour réaliser différentes interconnexions entre différentes plages de contact des circuits intégrés enchâssés dans les wafers.

Les modes de réalisation qui viennent d'être décrits sont susceptibles d'autres variantes de réalisation et d'autres applications en fonction des techniques, de l'équipement et des matériaux connus de l'homme de l'art désirant mettre en oeuvre l'invention. Des modes de réalisation du procédé selon l'invention peuvent également être directement appliqués aux structures d'empilements de puces. Dans ce cas, les trous sont pratiqués après que l'empilement de wafers a été découpé en différents empilements de puces qui ne sont pas encore interconnectées, et les colonnes conductrices sont faites a posteriori dans les différents empilements de puces. Des modes de réalisation de la présente invention peuvent également être mis en oeuvre dans le cadre des techniques d'empilement puce sur wafer ("die on wafer").

Les figures 7A à 7C illustrent un procédé alternatif pour réaliser les régions isolées 80 précédemment décrites, à travers lesquelles les trous et les colonnes conductrices sont formés. Lors d'une étape illustrée sur la figure 7A, qui remplace l'étape de la figure 1A, des puits 79 sont formés au lieu de former des tranchées 70. Par exemple, les puits 79 sont de forme circulaire et présentent le même diamètre et la même profondeur que le périmètre délimité par les tranchées sur la figure 1A. Ensuite, comme illustré sur la figure 7B, les puits 79 sont remplis d'un matériau diélectrique 90. Lorsque le wafer 10 a été aminci, tel que représenté schématiquement sur la figure 7C (qui est équivalente à la figure 1D, d'autres éléments du wafer n'étant pas représentés dans un souci de simplification du dessin), des régions isolées 80 ne comprenant que le matériau diélectrique 90 sont obtenues, au lieu de comprendre un matériau semi-conducteur entouré de matériau diélectrique.

L'homme de l'art notera également que le contact électrique latéral décrit ci-dessus, qui est obtenu entre une colonne conductrice et une zone conductrice (par exemple une plage de contact), peut également être obtenu lorsque les colonnes conductrices ne passent pas entièrement par toute la surface des zones conductrices, mais passent simplement à travers une partie de celles-ci de telle sorte qu'au moins un secteur angulaire de chaque colonne conductrice ou un de ses côtés (si elle n'est pas cylindrique) soit en contact électrique latéral avec les zones conductrices.

## Revendications

1. Procédé pour empiler et interconnecter des circuits intégrés, **caractérisé en ce qu'**il comprend les étapes consistant à :
- fournir au moins deux substrats (10-10"),
- former dans chaque substrat au moins une tranchée (70-70") ou un puits (79) délimitant un périmètre fermé dans chaque substrat,
- remplir la tranchée ou le puits de chaque substrat avec un matériau isolant (90),
- recouvrir la face avant de chaque substrat d'une couche de matériau diélectrique (90, 91),
- former, sur chaque substrat, au moins un circuit intégré (30-30") et au moins une zone conductrice (50-51", 50a-51b") connectée au circuit intégré, la zone conductrice étant située au-dessus de la tranchée ou du puits et électriquement isolée de la tranchée ou du puits par le matériau diélectrique (90, 91),
- amincir chaque substrat jusqu'à atteindre au moins le fond de la tranchée ou du puits, pour obtenir dans chaque substrat au moins une région isolée électriquement (80) délimitée par la tranchée ou le puits,
- assembler les substrats ensemble afin de former un empilement de substrats (100, 101, 102, 103, 104),
- pratiquer au moins un trou (71) à travers les substrats assemblés de telle sorte que le trou passe par la région isolée de chaque substrat, et
- remplir le trou d'un matériau électriquement conducteur afin d'obtenir une colonne conductrice (81-81b) qui traverse la région isolée de chaque substrat et présente au moins un secteur angulaire ou un côté en contact électrique latéral avec les zones conductrices.

2. Procédé selon la revendication 1, comprenant une étape consistant à découper l'empilement de substrats en au moins un empilement individuel de puces (200).

3. Procédé selon la revendication 2, dans lequel l'étape de découpe est effectuée avant les étapes de création d'au moins un trou dans les substrats assemblés.

4. Procédé selon l'une des revendications 1 à 3, comprenant une étape d'amincissement d'au moins un substrat (10', 10") effectuée après l'étape d'assemblage des substrats.

5. Procédé selon l'une des revendications 1 à 4, comprenant une étape de retrait partiel du matériau conducteur d'au moins une colonne conductrice (81) et une étape de remplacement du matériau conducteur retiré par un matériau non conducteur (82).

6. Procédé selon l'une des revendications 1 à 5, comprenant une étape consistant à réaliser dans au moins un des substrats, avant assemblage des substrats, des vias conducteurs (84) qui interconnectent au moins deux zones conductrices (50, 51) du substrat destinées à être également interconnectées par une colonne conductrice (81-81b).

7. Procédé selon l'une des revendications 1 à 6, comprenant des étapes consistant à :
- assembler au moins un premier, un second et un troisième substrat, et
- interconnecter au moins une zone conductrice du premier substrat avec au moins une zone conductrice du second substrat au moyen d'une première colonne conductrice en ne connectant aucune zone conductrice du troisième substrat à la colonne conductrice.

8. Procédé selon l'une des revendications 1 à 7, comprenant des étapes consistant à :
- assembler au moins un premier et un second substrat pour obtenir un empilement intermédiaire de substrats,
- interconnecter au moins une zone conductrice du premier substrat avec au moins une zone conductrice du second substrat au moyen d'une première colonne conductrice,
- assembler au moins un troisième substrat à l'empilement intermédiaire pour obtenir un empilement de substrats final, et
- interconnecter au moins une zone conductrice du premier et/ou du second substrat avec au moins une zone conductrice du troisième substrat, au moyen d'une seconde colonne conductrice.

## Patentansprüche

1. Verfahren zum Stapeln und Vernetzen von integrierten Schaltkreisen, **dadurch gekennzeichnet, dass** es die Schritte umfasst, die darin bestehen,:
- zumindest zwei Substrate (10-10") zu liefern,
- in jedem Substrat zumindest einen Graben (70-70") oder einen Topf (79), der in jedem Substrat einen geschlossenen Umfang abgrenzt, zu bilden,
- den Graben oder den Topf von jedem Substrat mit einem Isoliermaterial (90) zu füllen,
- die Vorderseite von jedem Substrat mit einer Schicht Dielektrikummaterial (90, 91) zu bedecken,
- auf jedem Substrat zumindest einen integrierten Schaltkreis (30-30") und zumindest eine mit dem integrierten Schaltkreis verbundene Leiterzone (50-51", 50a-51b") zu bilden, wobei sich die Leiterzone über dem Graben oder dem Topf befindet und anhand des Dielektrikummaterials (90, 91) elektrisch vom Graben oder vom Topf isoliert ist,
- jedes Substrat abzudünnen, bis zumindest der Boden des Grabens oder des Topfes erreicht wird, um in jedem Substrat zumindest einen elektrisch isolierten Bereich (80), der durch den Graben oder den Topf abgegrenzt ist, zu erhalten,
- die Substrate zusammenzubauen, um einen Substratstapel (100, 101, 102, 103, 104) zu bilden,
- derart zumindest ein Loch (71) durch die zusammengebauten Substrate auszubilden, dass das Loch durch den isolierten Bereich von jedem Substrat führt, und
- das Loch mit einem elektrisch leitenden Material zu füllen, um eine Leitersäule (81-81b) zu erhalten, die den isolierten Bereich von jedem Substrat durchquert und zumindest einen Winkelabschnitt oder eine Seite, der bzw. die im seitlichen elektrischen Kontakt mit den Leiterzonen steht, aufweist.

2. Verfahren nach Anspruch 1, das einen Schritt umfasst, der darin besteht, den Substratstapel in zumindest einen individuellen Chipstapel (200) zuzuschneiden.

3. Verfahren nach Anspruch 2, bei dem der Schritt des Zuschneidens vor den Schritten der Ausbildung von zumindest einem Loch in den zusammengebauten Substraten ausgeführt wird.

4. Verfahren nach einem der Ansprüche 1 bis 3, umfassend einen Schritt der Abdünnung von zumindest einem Substrat (10', 10"), der nach dem Schritt des Zusammenbaus der Substrate ausgeführt wird.

5. Verfahren nach einem der Ansprüche 1 bis 4, umfassend einen Schritt des partiellen Entfernens des Leitermaterials aus zumindest einer Leitersäule (81) und einen Schritt des Ersetzens des entfernten Leitermaterials durch ein nicht leitendes Material (82).

6. Verfahren nach einem der Ansprüche 1 bis 5, umfassend einen Schritt, der darin besteht, in zumindest einem der Substrate, vor dem Zusammenbau der Substrate, leitfähige Kontaktlöcher (84) auszuführen, die zumindest zwei Leiterzonen (50, 51) des Substrats vernetzen, die ebenfalls durch eine Leitersäule (81-81b) vernetzt sein sollen.

7. Verfahren nach einem der Ansprüche 1 bis 6, umfassend Schritte, die darin bestehen,:
- zumindest ein erstes, ein zweites und ein drittes Substrat zusammenzubauen, und
- zumindest eine Leiterzone des ersten Substrats mit zumindest einer Leiterzone des zweiten Substrats anhand einer ersten Leitersäule zu vernetzen, und ohne dass eine Leiterzone des dritten Substrats mit der Leitersäule verbunden wird.

8. Verfahren nach einem der Ansprüche 1 bis 7, umfassend Schritte, die darin bestehen,:
- zumindest ein erstes und ein zweites Substrat zusammenzubauen, um einen Substratzwischenstapel zu erhalten,
- zumindest eine Leiterzone des ersten Substrats mit zumindest einer Leiterzone des zweiten Substrats anhand einer ersten Leitersäule zu vernetzen,
- zumindest ein drittes Substrat mit dem Zwischenstapel zusammenzubauen, um ein Endsubstratstapel zu erhalten, und
- zumindest eine Leiterzone des ersten und/oder des zweiten Substrats mit zumindest einer Leiterzone des dritten Substrats anhand einer zweiten Leitersäule zu vernetzen.

## Claims

1. A method for stacking and interconnecting integrated circuits, **characterized in that** it comprises the steps of:
- providing at least two substrates (10-10"),
- forming in each substrate at least one trench (70-70") or a well (79) delimiting a closed perimeter in each substrate,
- filling the trench or the well of each substrate with an insulating material (90),
- covering the front face of each substrate with a layer of dielectric material (90, 91),
- forming, on each substrate, at least one integrated circuit (30-30") and at least one conducting zone (50-51", 50a-51b") connected to the integrated circuit, the conducting zone being located above the trench or the well and electrically isolated from the trench or the well by the dielectric material (90, 91),
- thinning each substrate until at least the bottom of the trench or the well is reached, to obtain in each substrate at least one electrically isolated region (80) delimited by the trench or the well,
- assembling the substrates together to form a stack of substrates (100, 101, 102, 103, 104),
- making at least one hole (71) through the assembled substrates such that the hole runs through the isolated region of each substrate, and
- filling the hole with an electrically conductive material to obtain a conducting column (81-81b) which passes through the isolated region of each substrate and has at least one angular sector or one side in lateral electrical contact with the conducting zones.

2. Method according to claim 1, comprising a step of cutting the stack of substrates into at least one individual stack of chips (200).

3. Method according to claim 2, wherein the cutting step is performed before the steps of creating at least one hole in the assembled substrates.

4. Method according to one of claims 1 to 3, comprising a step of thinning at least one substrate (10', 10") performed after the step of assembling the substrates.

5. Method according to one of claims 1 to 4, comprising a step of partially removing the conductive material from at least one conducting column (81) and a step of replacing the conductive material removed with a non-conductive material (82).

6. Method according to one of claims 1 to 5, comprising a step of making in at least one of the substrates, before assembling the substrates, conducting vias (84) which interconnect at least two conducting zones (50, 51) of the substrate also intended to be interconnected by a conducting column (81-81b).

7. Method according to one of claims 1 to 6, comprising steps of:
- assembling at least a first, a second and a third substrate, and
- interconnecting at least one conducting zone of the first substrate with at least one conducting zone of the second substrate by means of a first conducting column while not connecting any conducting zone of the third substrate to the conducting column.

8. Method according to one of claims 1 to 7, comprising steps of:
- assembling at least a first and a second substrate to obtain an intermediate stack of substrates,
- interconnecting at least one conducting zone of the first substrate with at least one conducting zone of the second substrate by means of a first conducting column,
- assembling at least a third substrate to the intermediate stack to obtain a final stack of substrates, and
- interconnecting at least one conducting zone of the first and/or the second substrate with at least one conducting zone of the third substrate, by means of a second conducting column.
